# EUROPEAN PATENT APPLICATION

(11) **EP 1 486 743 A1**
(43) Date of publication of application: **15.12.2004**
(21) Application number: 03742659.0
(22) Date of filing: 03.02.2003
(51) Int. Cl.: F25B 27/02, F25B 21/02, F24F 7/08, F24F 5/00

(54) **HEAT RECOVERY UNIT AND HEAT RECOVERY SYSTEM OF BUILDING UTILIZING IT**

(30) Priority: 25.02.2002 JP 2002048023; 08.08.2002 JP 2002232084
(71) Applicant: Famm Co. Ltd., Yokohama-shi, Kanagawa 231-0028 (JP); Arude Engineering Co. Ltd., Tokyo 103-0011 (JP)
(72) Inventor: YAMAMOTO, Hideyo, c/o FAMM CO.LTD., Yokohama-shi, Kanagawa 231-0028 (JP)
(74) Representative: Hofer, Dorothea, Dipl.-Phys.
(86) International application number: PCT/JP2003/001058
(87) International publication number: WO 2003/071200

(57) **Abstract**

The objective of the present invention is to provide a system which allows efficient air-conditioning heat recovery during ventilation and is applicable to ordinary housing. In order to achieve the above objective, a central ventilation fan 110 is connected to a heat exchanger 120 via a ventilation pipe. Air collected in the central ventilation fan 110 is emitted via the heat exchanger 120 from a device after recovering heat from heated exhaust air from each room by the heat exchanger 120. On the other hand, the heat exchanger 120 is connected to a tank 130 via a water suction/ drainage pipe. Water drawn up from the tank 130 by a pump 140 is heated by the heat exchanger 120 and then returned to the tank 130 again. The heat exchanger 120 uses the Peltier device to cool the exhaust air from the central ventilation fan 110, and heat water in the tank 130 at the same time, thereby efficiently transferring air heat from each room to water. Efficient transfer of heat using the Peltier device allows a higher temperature of the water from the heat exchanger than the exhaust air temperature.

## Description

### Technical Field

The present invention relates to a heat recovery device and a building heat recovery system using the same to efficiently recover air conditioning heat during ventilation of buildings.

### Background of the Invention

Urgent solutions for environmental issues have been desired. In particular, a problem of reduction in CO₂ emission has come under close scrutiny after ratification of the Kyoto Protocol. Energy saving must be promoted in every field throughout the nation in order to reduce CO₂ emission. Therefore, energy saving is required even for heating and cooling in small buildings, more specifically, in ordinary housing.

On the other hand, with ordinary housing, a concern for ventilation in housing has grown due to health problems. However, good ventilation leads to inefficient thermal energy emission during ventilation of air-conditioned housing.

Consequently, a system which allows efficient air-conditioning heat recovery during ventilation is currently required.

### Disclosure of Invention

The objective of the present invention is to provide a system which allows efficient air-conditioning heat recovery during ventilation and is applicable to ordinary housing.

In order to achieve the above-described objective, a building heat recovery system, comprising: a central ventilation fan for collecting exhaust air from each room in the building for ventilation; a ventilation heat recovery device which has a heat sink, a Peltier device connected to the heat sink, a medium connected to the Peltier device, and a power supply for the Peltier device, and conducts exhaust air heat from the central ventilation fan to a medium; a highly efficient thermal conduction sheet for radiating heat conducted via the medium to each room.

A highly efficient thermal conduction material is used as the medium, and heat is conducted without transferring via the medium. Such configuration allows reduction in difference in temperature between the top and the bottom of a room or between rooms.

### Brief Description of the Drawings

FIG. 1 shows a configuration of a heat recovery device of an embodiment;
FIG. 2 shows a detailed configuration of a heat exchanger used in the heat recovery device;
FIG. 3 is a diagram describing a Peltier device used in the heat exchanger;
FIG. 4 shows an example of applying a heat recovery device to ordinary housing;
FIG. 5 shows a configuration of housing in which a building heat recovery system of the embodiment is provided;
FIG. 6 shows a configuration of a radiator panel used in the building heat recovery system of the embodiment;
FIG. 7 shows a configuration of a heat recovery system of another embodiment; and
FIG. 8 is a diagram describing connection between the radiator panel and a highly efficient thermal conduction material.

### Best Mode for Implementing the Invention

An embodiment of the present invention is described while referencing the drawings.

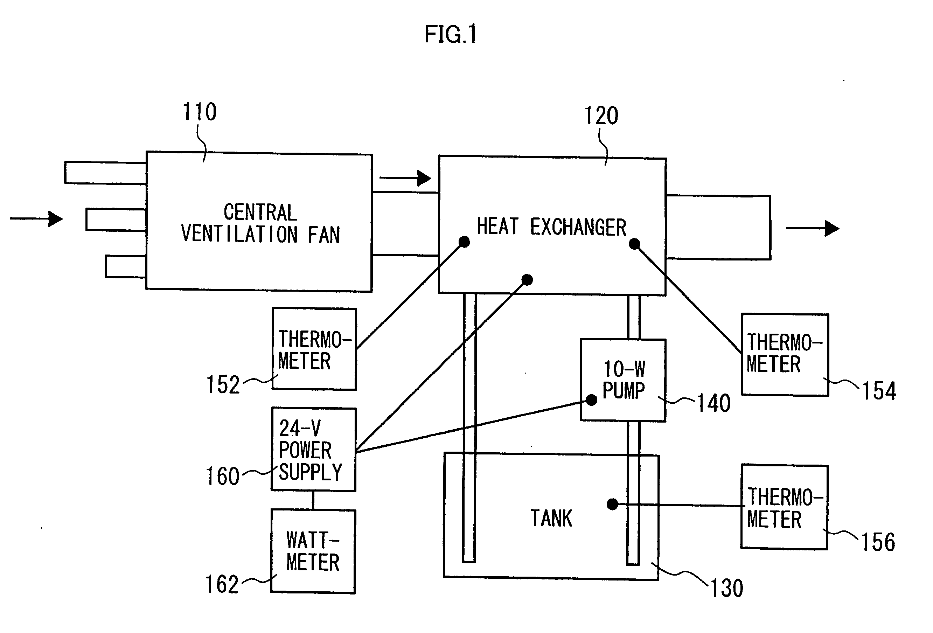

FIG. 1 shows an entire configuration of a heat recovery device which conducts ventilation heat to a medium. A case of heating each room in a building using the device shown in FIG. 1 is described. The heat recovery device of the embodiment uses water as a heat medium.

FIG. 1 shows an entire configuration of a heat recovery device which conducts ventilation heat to a medium. A case of heating each room in a building using the device shown in FIG. 1 is described. The heat recovery device of the embodiment uses water as a heat medium. The heat medium for the heat recovery device may be any fluid: liquid such as oil, gas such as air, solid, or a mixture thereof. On the other hand, to be described later, there is a case where fluid is not used as a heat medium.

In FIG. 1, air emitted from each room for ventilation is collected through a central ventilation fan 110. The central ventilation fan 110 is connected to a heat exchanger 120 via a ventilation pipe. Air collected in the central ventilation fan 110 is emitted from the heat recovery device after recovering heat from heated exhaust air by the heat exchanger 120. On the other hand, the heat exchanger 120 is connected to a tank 130 via a water suction/ drainage pipe. Water drawn up from the tank 130 by a pump 140 is heated by the heat exchanger 120 and then returned to the tank 130 again.

The heat exchanger 120 uses the Peltier device to cool the exhaust air from the central ventilation fan 110, and heat water in the tank 130 at the same time, thereby efficiently transferring air heat from each room to water. Efficient transfer of heat using the Peltier device allows a higher temperature of the water from the heat exchanger than the exhaust air temperature.

By reversing the direction of current flowing into the Peltier device for cooling, exhaust air from the central ventilation fan 110 is heated and water is cooled by the heat exchanger 120, resulting in generation of cold water. In this case, usage of the Peltier device allows decrease in this cold water temperature to be lower than an exhaust air temperature from a room.

Note that a thermometer 154 measures water temperature flowing into the heat exchanger 120; a thermometer 152 measures water temperature flowing out from the heat exchanger 120; and a thermometer 156 measures water temperature in the tank 130. A power supply 160 supplies power, which is then measured by a wattmeter 162, to the Peltier device in the heat exchanger 120 and a pump.

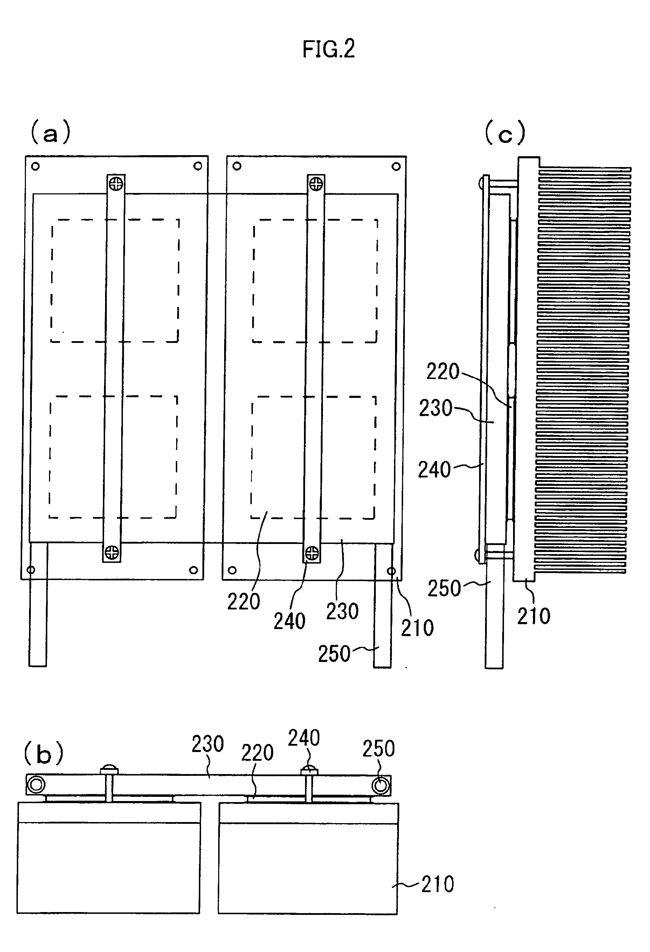

FIG. 2 shows a detailed configuration of the heat exchanger 120 in FIG. 1. FIG. 2 (a) is a front view of the heat exchanger 120, FIG. 2 (b) is a planar view thereof, and FIG. 2C is a lateral view thereof.

The heat exchanger 120 is made up of heat sinks 210, Peltier devices 220, water suction/ drainage pipes 250, and a container 230. Exhaust air from the central ventilation fan 110 is emitted from the heat exchanger via the heat sinks 210, while conducting exhaust air heat to the heat sinks 210. Water flowing through the heat exchanger 120 from the tank 130 enters the container 230 via one of the water suction/drainage pipes 250, flows out from the other water suction/ drainage pipe 250, and returns to the tank 130.

One surface each Peltier device 220 is bonded to a flat surface of corresponding heat sink 210, and the other is bonded to one surface of the container 230. When applying a certain amount of current to the Peltier devices 220, one surface thereof becomes a cooled surface, and the other becomes a heated surface. When reversing the direction of the current, the cooled surface and the heated surface are reversed.

Consequently, in the case of recovering air-conditioning heat using the heat exchanger and then heating water in the container 230, a certain amount of current should be applied so that the Peltier device 220 sides bonded to the heat sink 210 become cooled surfaces and the other sides surfaces bonded to the container 230 become heated surfaces. This makes the Peltier device 220 sides bonded to the heat sink 210 cool exhaust air, and the Peltier devices 220 sides bonded to the container 230 heat water. On the other hand, when cooling water by recovering air-conditioning cold air, a certain amount of current is applied to the Peltier devices 220 in a direction opposite to the case of heating. This makes the Peltier devices 220 bonded to the heat sink 210 heat exhaust air, and the Peltier devices 220 sides bonded to the container 230 cool water.

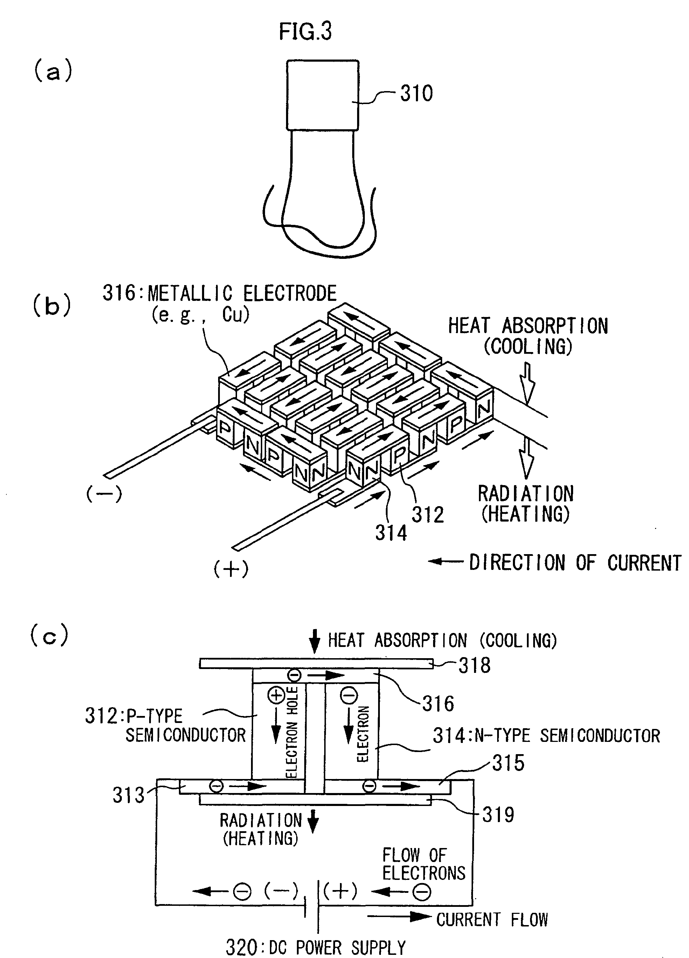

FIG. 3 is a diagram describing an example of a configuration of the Peltier device 220 used in the above-described heat exchanger.

FIG. 3 (a) is the exterior of the Peltier device 220 used in the heat exchanger. FIG. 3 (b) shows an example of an internal configuration of the Peltier device. FIG. 3 (c) shows an operation of each Peltier device shown in FIG. 3 (b).

As shown in FIG. 3 (b), the large-size Peltier device shown in FIG. 3 (a) has a configuration where multiple small Peltier devices are electrically connected in series, and thermally connected in parallel. FIG. 3 (c) is a diagram of a simple Peltier device describing the operation of the Peltier device. When a direct-current power supply 320 is connected to the Peltier device, current flows from the underside of an N-type semiconductor 314 to the underside of a P-type semiconductor 312 via an electrode 316 thereabove. Energy and electrons transfer in a direction opposite to that of the current. Since the N-type semiconductor 314 receives from the electrode 316 energy for transferring electrons from the electrode 316 thereabove to the N-type semiconductor and energy for transferring in the N-type semiconductor 314 to an electrode 315 thereunder , energy on the electrode 316 thereabove becomes insufficient, resulting in decrease in temperature. On the other hand, from the electrode 315 thereunder, energy that electrons have taken is released, resulting in increase in temperature. In the P-type semiconductor 312, electron holes, which operate as electrons, transfer energy. As a result, the total heat quantity absorbed by a heat absorption surface 318 and the heat quantity corresponding to the total supplied power are added together, and emitted to a radiator surface 319. This heating (cooling) effect is in proportion to the magnitude of the current and the number of semiconductors. At this time, usage of a solar battery as the power supply used in the Peltier device allows implementation of a further environmentally favorable system.

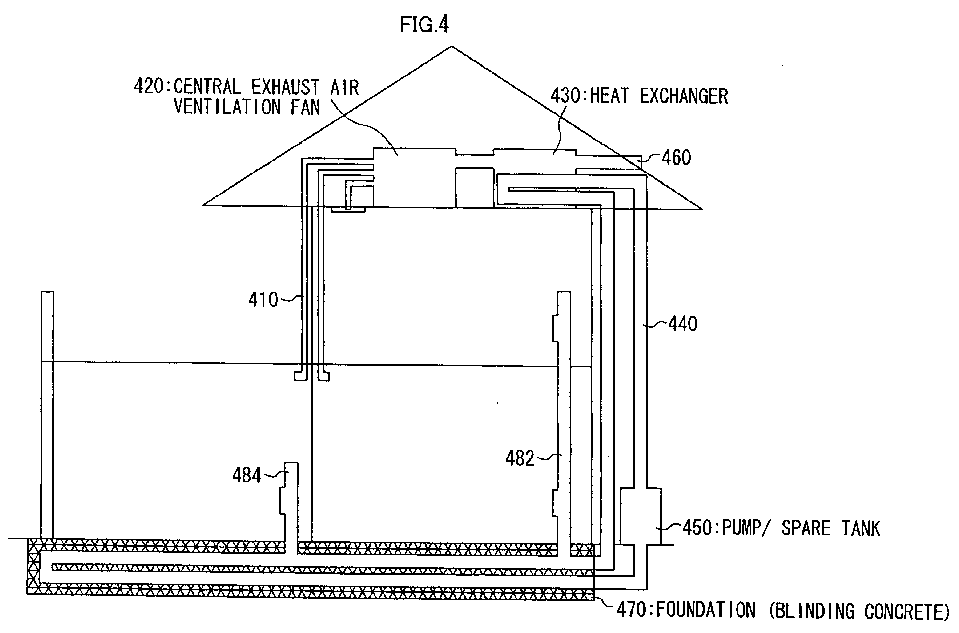

FIG. 4 shows an example of applying the heat recovery device in FIG. 1 to an ordinary housing.

In FIG. 4, a central ventilation fan 420 and a heat exchanger 430 are connected to each other by a pipe, and provided in a ceiling, for example. Ventilation air from each room is sent to the central ventilation fan 420 via a ventilation pipe 410 and emitted from an exhaust air pipe 460 via the heat exchanger 430. On the other hand, a pump/ spare tank 450 is provided outdoors. A water suction/ drainage pipe 440 is deployed on, for example, the foundation of a house (under floor blinding concrete) 470 via the heat exchanger 430, and connected to the pump/ spare tank 450 again. Usage of the foundation 470 allows increase in heat capacity, and increase in heat storage capacity.

In the heat exchanger 430, a certain amount of current flows through the Peltier devices so that water can be heated for warming, or that water can be cooled for cooling. Heated or cooled water circulates along the water suction/ drainage pipe 440, and returns to the pump/ spare tank 450.

This heat recovery device allows heating (cooling) of each room using heat (cold heat) stored in water. In this case, as shown in FIG. 4, heated water may be sent to each room via pipes 482 and 484 so that the heat exchanger can assist cooling and heating each room. Usage of the Peltier devices in the heat exchanger as with the case in FIG. 2 improves efficiency. In addition, the Peltier devices may be used for floor heating (floor cooling).

On the other hand, when collectively taking air in from the outside for ventilation of a building, the Peltier devices may be used for heating (cooling) the air intake. In this case, usage of the heat exchanger with the Peltier devices as shown in FIG. 2 improves the heat efficiency.

In this system, the location of each device is not limited to the above, and, for example, the heat exchanger 430 may be provided outdoors. In addition, the location of the water suction/ drainage pipe 440 is not limited to the above, and, it may be deployed, for example, under a floor, in walls, or in a ceiling of each room.

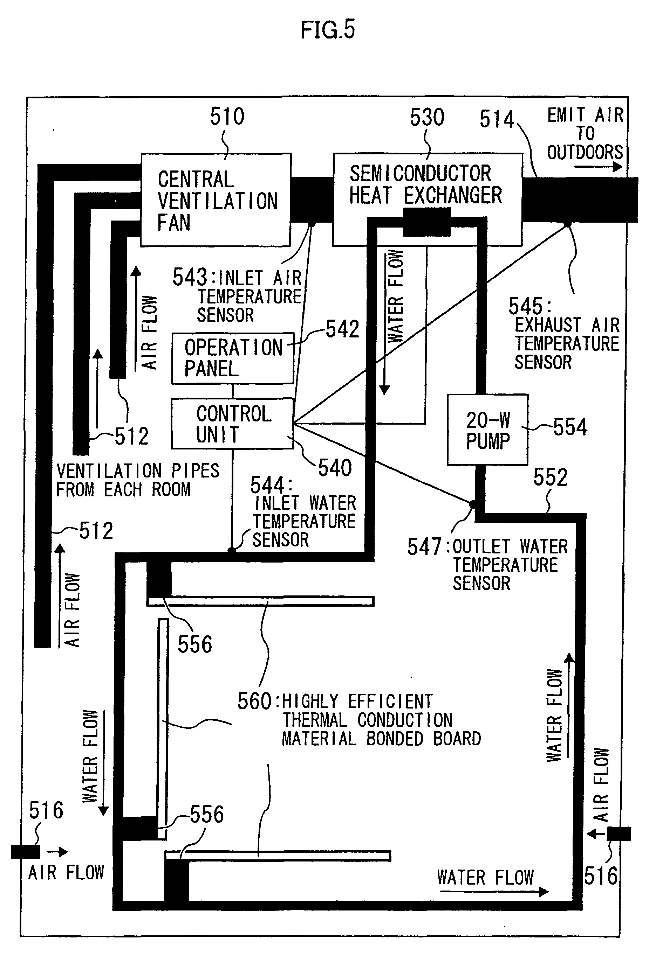

FIG. 5 shows a configuration of a well insulated and air-tight panel housing in which the building heat recovery system of the embodiment is provided. In FIG. 5, this housing is well insulated using a heat insulating material so as to prevent heat within the housing from escaping. This housing is well insulated by deploying an external heat insulation material even under floor.

Exhaust air from each room in the housing is collected by a central exhaust air/ heat recovery device via ventilation pipes 512 provided in each room. The central exhaust air/ heat recovery device made up of a central ventilation fan 510, which collects exhaust air from the ventilation pipes 512, and a heat exchanger 530, which recovers and stores exhaust air heat in a medium, recovers and stores exhaust air heat in a medium, and then emits the exhaust air from a pipe 514 to the outside of the housing. The central exhaust air/ heat recovery device recovers not only heat during heating but also cold heat for cooling. The heat exchanger 530 is controlled by a control unit 540, which is operated using an operation panel. The control unit 540 also monitors temperatures using an intake air temperature sensor 543, an exhaust air temperature sensor 545, an inlet water temperature sensor 544, and an outlet water temperature sensor 547. The heat exchanger 530 will be described below in detail.

Heat (including cold heat) recovered by the central exhaust air/ heat recovery device is sent back to the housing again from a radiator panel (highly efficient thermal conduction sheet bonded board) 560 provided in each room via a medium such as water and the heat exchanger 530. As shown in FIG. 5, this radiator panel 560 may be provided on inner walls, in a roof, or under floors. The radiator panel and an inner wall may be unified and structured as a single body. A configuration of the radiator panel (highly efficient thermal conduction sheet bonded board) 560 is described below.

The heat exchanger 530 used in the central exhaust air/ heat recovery device is the above-described heat exchanger 530 with the Peltier devices. In the heat exchanger 530, heat sinks provided in exhaust air are connected to the Peltier devices, thereby transferring heat (cold heat) from those Peltier devices to a medium.

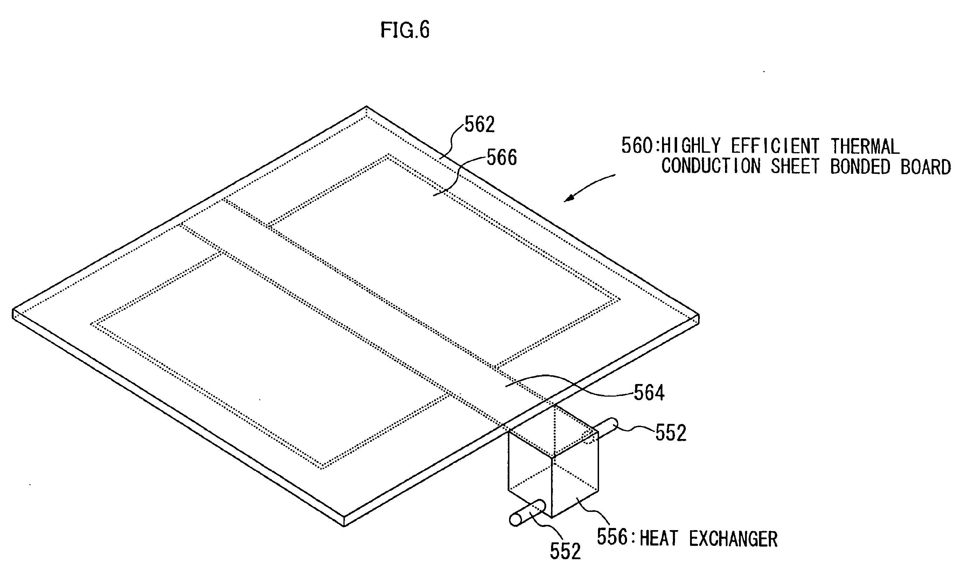

FIG. 6 shows a configuration of the radiator panel 560 used in the heat recovery system of the embodiment.

The radiator panel (highly efficient thermal conduction sheet bonded board) 560 has a configuration where a highly efficient thermal conduction sheet (e.g., a graphite sheet) 566 is bonded to a board 562. Thermal conduction between the highly efficient thermal conduction sheet 566 and a heat exchanger 556 including a medium such as water is provided by a similar highly efficient thermal conduction sheet 564. Since a medium within the heat exchanger 556 moves slowly, sufficient thermal conduction to the highly efficient thermal conduction sheet 564 can be provided.

Configuration of the radiator panel with a highly efficient thermal conduction sheet allows generation of a lightweight and highly efficient radiator panel.

In addition, since a highly efficient thermal conduction sheet deployed on part of a surface of that radiator panel 560 provides thermal conduction, this panel can be deployed anywhere by nailing, for example.

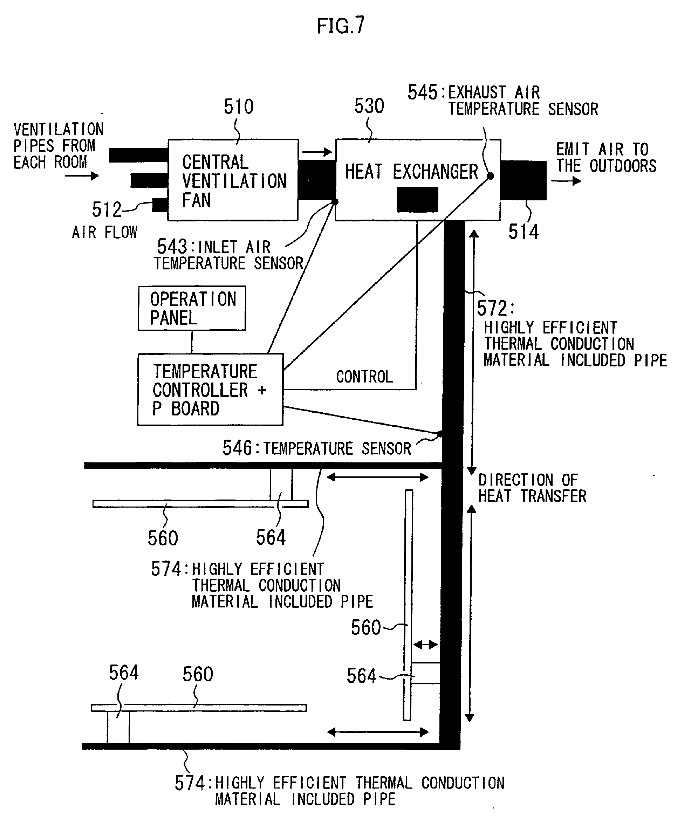

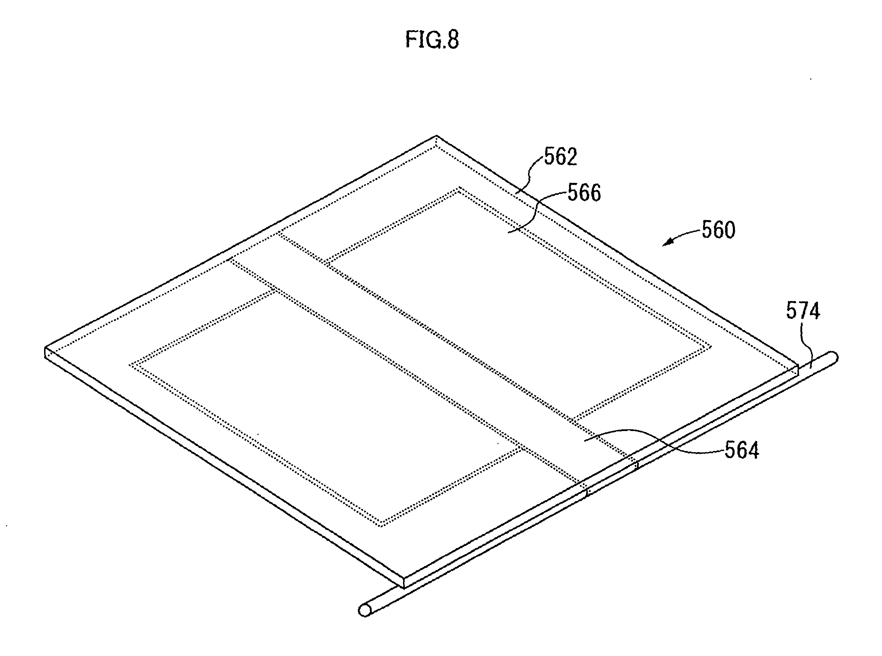

FIG. 7 shows a configuration of a building heat recovery system according to another embodiment of the present invention. FIG. 8 is a diagram describing connection among the heat recovery system in FIG. 4, the radiator panel (highly efficient thermal conduction sheet bonded board) 560, and a medium.

According to this system, as shown in FIG. 7, heat from each room is conducted to a highly efficient thermal conduction material by the heat exchanger 530 for ventilation. The highly efficient thermal conduction material makes direct contact with the Peltier devices in the heat exchanger, to conduct heat for ventilation. This highly efficient thermal conduction material (e.g., graphite) is stored in a pipe 572 to conduct heat to each room for ventilation. A material for conducting heat from the highly efficient thermal conduction material to that pipe or preventing heat dissipation is selected according to location. In each room, as shown in FIG. 8, the highly efficient thermal conduction material sheet 564 conducts heat to the highly efficient thermal conduction material sheet 566 on the radiator panel 560 from the highly efficient thermal conduction material included pipe 574, and the radiator panel 560 radiates heat. In this case, in the place where the highly efficient thermal conduction material sheet 564 makes contact with the pipe 574, a highly thermal conductivity material (e.g., Copper) may be provided.

As described above, since this heat recovery system provides thermal conduction using a highly efficient thermal conduction material, there is no need for motive energy for transferring a medium.

In addition, in the case where a radiator panel is provided in a ceiling or under a floor in a room, if there is not only heat recovered from exhaust air but also difference in temperature between the top and the bottom of a room or between rooms, the heat for the difference in temperature is absorbed from the highly efficient thermal conduction sheet on the radiator panel, and then conducted via the highly efficient thermal conduction material in the pipe, which allows elimination of difference in temperature within a house. This is effective even when heat from exhaust air is not recovered.

This is because the highly efficient thermal conduction sheet on the radiator panel or the highly efficient thermal conduction material in the pipe conducts heat bidirectionally, and this allows arbitrary thermal conduction.

### INDUSTRIAL AVAILABILITY

The heat recovery device according to the present invention allows efficient operation at low costs and facilitates maintenance. In addition, less power consumption leads to energy saving. Furthermore, noise can be suppressed.

## Claims

1. A ventilation heat recovery device, comprising:
a heat sink;
a Peltier device connected to the heat sink;
a medium connected to the Peltier device; and
a power supply for the Peltier device, wherein
heat including cold heat is transferred from ventilation to a medium via the Peltier device.

2. A building heat recovery system, comprising:
a central ventilation fan for collecting exhaust air from each room in the building for ventilation;
a ventilation heat recovery device, which conducts exhaust air heat from the central ventilation fan to a medium, and comprises a heat sink, a Peltier device connected to the heat sink, a medium connected to the Peltier device, and a power supply for the Peltier device; and
a highly efficient thermal conduction sheet for radiating heat conducted via the medium to each room.

3. The building heat recovery system according to Claim 2, wherein
a highly efficient thermal conduction material is used as said medium, and
heat is conducted without transferring via the medium.
